(19) Europäisches Patentamt
European Patent Office
Office européen des brevets

(11) **EP 3 232 217 B1**

(12) **EUROPEAN PATENT SPECIFICATION**

(45) Date of publication and mention of the grant of the patent:
**01.12.2021 Bulletin 2021/48**

(51) Int Cl.:
*G01R 31/42* *(2006.01)*   *G01R 31/64* *(2020.01)*
*H02M 1/12* *(2006.01)*

(21) Application number: **16165491.8**

(22) Date of filing: **15.04.2016**

(54) **DETERMINING OF FILTER CAPACITANCES**

BESTIMMUNG VON FILTERKAPAZITÄTEN

DÉTERMINATION DES CAPACITÉS DE FILTRAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**18.10.2017 Bulletin 2017/42**

(73) Proprietor: **ABB Schweiz AG**
**5400 Baden (CH)**

(72) Inventors:
• **Salmi, Esa**
**00380 Helsinki (FI)**
• **Tervo, Hermanni**
**00380 Helsinki (FI)**
• **Viitanen, Tero**
**00380 Helsinki (FI)**

(74) Representative: **Kolster Oy Ab**
**(Salmisaarenaukio 1)**
**P.O. Box 204**
**00181 Helsinki (FI)**

(56) References cited:
**EP-A1- 2 858 228**   **EP-A2- 2 654 201**
**WO-A1-2015/071378**   **US-A1- 2013 057 297**

**Description**

FIELD OF THE INVENTION

The present invention relates to determining filter capacitances, and particularly to monitoring of a capacitance value of an LC or LCL filter of an inverter.

BACKGROUND OF THE INVENTION

Inverters are devices used for converting DC voltage to AC voltage. The AC voltage can further be fed to a grid or to a load. Inverters can also be used to feed power to both directions and therefore function both as a controlled rectifier and as an inverter.

Inverters which are interfacing the grid are referred to as grid-side converters. Such a grid-side converter may be an inverter which is adapted to feed power to the grid in power generation applications. The grid-side converter may also be a controlled rectified which typically draws power from the grid. Such controlled rectifiers are used in frequency converters that are used for supplying electrical power to a load. The grid-side converters have controlled power semiconductor components which enable to transmit power to both directions.

The grid-side converters are typically connected to the grid using a LC- or LCL filter interconnecting the converter and the grid. The filter is used for filtering the harmonics produced by the inverter and thereby tidying the current waveform. The filter may consist of an inductive element connected to each output phase of the converter together with capacitors connected in star or delta connection between the phases. The capacitors are connected between the inductive elements and the grid (LC-filter). For increasing the attenuation of the filter, the filter may comprise a second inductive component in each phase (LCL-filter) connected after the capacitors. As well as grid-side converters, also motor drives can be equipped with low-pass filters, such as LC- or LCL-filters connected between the inverter and the motor.

As the capacitors used in the filter are aging, the capacitances of the capacitors decrease. The decrease of the capacitances leads to decreased performance of the filter. Further, the controller of the grid-side converter may be tuned to certain capacitance values. When the capacitances change, the operation of the converter may not be optimal.

The decrease of capacitance of the filter capacitors could be determined by carrying out direct measurements from the capacitors. However, the measurement of capacitance values is a not feasible solution as the capacitors may be situated inside the converter structures. Further, the manual measurement of the capacitances would be a time-consuming task.

Document WO 2015/071378 A1 discloses a method for determining the capacitance values of an output filter of an inverter. The determination of the capacitance values is based on forming an island network and measuring currents and voltages.

Document US 2013/057297 A1 discloses a method for determining the degradation of filter capacitances. The determination is carried out during the use of the device and is based on analysing the changes in the fundamental frequency component of measured current or voltage.

BRIEF DESCRIPTION OF THE INVENTION

An object of the present invention is to provide a method and an apparatus for implementing the method so as to solve the above problems. The objects of the invention are achieved by a method and an apparatus which are characterized by what is stated in the independent claims. The preferred embodiments of the invention are disclosed in the dependent claims.

The invention is based on the idea of forming a resonance circuit from the inductive and capacitive components of the grid-side converter using the controlled switches of the converter. When the filter capacitors are charged and the filter is disconnected from the grid, a resonance circuit can be formed by controlling the switches of the converter to a state that allows the charge from the capacitors to discharge through the inductive components. By measuring current or voltage in the resonance circuit during the resonance, the condition of the capacitors of the filter can be determined. Typically, the condition of the capacitors is determined by comparing the obtained capacitance value to a stored value.

An advantage of the method and apparatus of the invention is that the gradually decreasing capacitance of the filter can be determined without any external devices using only the circuitry of the inverter. Further, the capacitance can be determined regularly, and the inverter device itself can indicate when the capacitance of the filter is under a certain limit, for example.

The determination of the capacitance can be made as an automated procedure or it can be made upon a request of the operator of the device.

BRIEF DESCRIPTION OF THE DRAWINGS

In the following the invention will be described in greater detail by means of preferred embodiments with reference to the attached drawings, in which

Figure 1 shows a converter circuit with an LCL filter;
Figure 2 shows an equivalent circuit of Figure 1 during a resonance;
Figure 3 shows a converter circuit with an LCL filter;
Figure 4 shows an equivalent circuit of Figure 3 during a resonance; and
Figures 5, 6 and 7 show various current and voltage waveforms relating to Figure 1 and 2.

DETAILED DESCRIPTION OF THE INVENTION

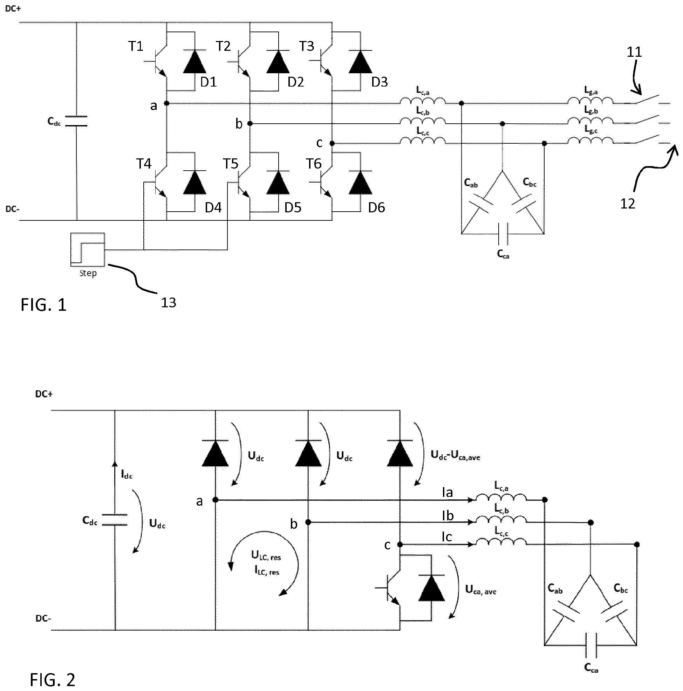

Figure 1 shows a main circuit of a mains converter. The mains converter is also referred to as grid-side converter or grid-side inverter, and in the following it is referred as an inverter although it is able to transfer power to both directions and thus act as an inverter and as a rectifier. The inverter of Figure 1 is formed of controllable semiconductor switches T1 ... T6 and corresponding antiparallel diodes D1 ... D6. Two semiconductor switches are connected in series with antiparallel switches to form an inverter leg. Each inverter leg forms a phase of the inverter in the point between the series connected switch components in a known manner.

The series connected switch components are connected between positive voltage bus DC+ and negative voltage bus DC-. The upper switch components are connected to the positive voltage bus and the lower switch components are connected to the negative voltage bus. The inverter of Figure 1 is shown to be a voltage source inverter as the voltage buses form a voltage source and a capacitor $C_{dc}$ is connected between the voltage buses.

Figure 1 also shows an LCL filter connected to the phases of the inverter. The LCL filter comprises inductive components, such as inductors, connected at their first ends to the phases of the inverter, i.e. to the points between the upper and lower semiconductor switches of each inverter leg. The shown inverter is a three-phase inverter and each phase is connected to respective filter inductance $L_{c,a}$, $L_{c,b}$, $L_{c,c}$. The filter further comprises capacitors connected to the second ends of the inductive components and connecting the second ends of the inductive components together. In Figure 1 the capacitors are connected in delta between the different phases. Capacitor $C_{ab}$ is connected between the second ends of the inductive components of phases a and b, capacitor $C_{bc}$ is connected between the second ends of the inductive components of phases b and c, and capacitor $C_{ca}$ is connected between the second ends of the inductive components of phases c and a.

The LCL filter shown in Figure 1 also comprises grid-side inductive components $L_{g,a}$, $L_{g,b}$, $L_{g,c}$, such as inductors, connected in series with the converter-side inductive components connected to the phases of the inverter. The filter structure and the inverter shown in Figure 1 are known as such. It is to be noted, that without the grid-side inductive components the filter is an LC filter.

Figure 1 also shows switching means 11 which is able to disconnect the filter and thus the inverter from the alternating voltage source 12, such as voltage grid 12 or a rotating electrical machine. The switching means is typically a contactor or air circuit breaker. The switching means provide a separation for the device from the alternating voltage source. As mentioned, the alternating voltage source may be a voltage grid or a rotating electrical machine, such as a motor or generator. As known, in some situations a motor may act as a generator producing power which is fed through the filter to the converter. In the following, the alternating voltage source is referred to as a voltage grid.

In the method of the invention, the filter capacitance of the filter is determined. The filter is connected to the phases of the converter and adapted to be connected to a voltage grid. The converter of the disclosure may be operating only for providing power to a network and the filter is then connected to the output phases of the converter. The filter, and thus the converter, is adapted to be connected to the voltage grid.

In the method of the invention, the capacitors of the filter are charged. Once the method is carried out after the inverter has been in use, the filter capacitors are charged to a voltage. If, on the other hand the switching means are open, and the filter capacitances are not charged, the charging of the filter capacitor can be carried out also from the charge of the intermediate circuit capacitor $C_{dc}$, as will be described later. Generally, the charging of the filter capacitor can be carried out by using any source, device or method. The filter capacitor can be charged from intermediate circuit of a current source inverter, for example.

If the switching means 11 connect the filter to the voltage grid 12, then the switching means are opened to disconnect the filter from the voltage grid and the semiconductor switches of the converter bridge are controlled such that the filter capacitors are short-circuited through the inductive components.

Figure 1 shows as an example also a controller 13 connected to control switch components T4 and T5 which are used in an embodiment to form a resonance circuit.

Figure 2 shows an equivalent circuit of Figure 1 when the filter capacitors are short circuited according to an embodiment of the invention. In the embodiment, two lower semiconductor switches T4, T5 are controlled conductive and the filter capacitors are short-circuited through the inductive components $L_{c,a}$, $L_{c,b}$ of the filter. The capacitors and the inductors of the filter form a resonance circuit and the resonance frequency of the circuit is dictated by the values of the capacitances of the capacitors and the inductances of the inductors. The inductances of commonly used inductive components are not changing due to aging, and therefore only changing property affecting the resonance frequency is the capacitance of filter. In the embodiment of Figure 2 two lower side semiconductor switches are used in forming the resonance circuit. In another embodiment of the invention, the resonance circuit is built by controlling two upper side semiconductor switches to controlling state while other semiconductor switches are blocking.

Further in the invention a current or a voltage is measured in the circuit in which the current is flowing, and from the oscillation of the measured current or voltage the condition of the capacitors of the filter is determined.

Once two of the lower semiconductor switches T4, T5, T6 are controlled conductive and the upper semiconductor switches are not conducting, a circuit is formed from the filter capacitors through the inductive components of the phases of which the lower semiconductor switches are conductive. The circuit is further closed through the conductive components and negative DC bus. In the example of Figure 2, the current path is formed from the filter capacitors through inductor $L_{c,a}$, semiconductor switch component T4, negative DC bus DC-, semiconductor switch component T5 and inductor $L_{c,b}$ back to filter capacitors. As a resonance circuit is formed, the current changes its directions in the circuit and voltage of the capacitors oscillate. Similar current path is formed also when two of the upper semiconductor switches T1, T2, T3 are controlled conductive and the lower semiconductor switches are blocking.

Once the upper switch components are in blocking state, a voltage with a magnitude of the voltage of DC capacitor $C_{dc}$ is built across the upper diodes of the phases in which the lower switch components are controlled conductive. In the phase in which lower switch component is not controlled the voltage over the lower diode corresponds to average voltage of the filter capacitor of that phase and the voltage over the upper diode in that phase is the difference between voltage of the DC capacitor and the voltage over the lower diode.

The oscillation frequency $f_{res}$ of the formed LC-circuit can be calculated as

$$f_{res} = \frac{1}{2\pi} \cdot \frac{1}{\sqrt{L_{TOT}C_{TOT}}} \tag{1}$$

in which $L_{TOT}$ is the total inductance of the inductances in the oscillating circuit and $C_{TOT}$ is the total capacitance of the filter circuit when the capacitances are connected in delta as shown in Figures 1 and 2. The capacitors can also be connected in star connection. In the case of Figure 2, the total capacitance in the circuit is formed of series connection of capacitors $C_{bc}$ and $C_{ca}$, and the series connection in parallel with capacitor $C_{ab}$.

$$C_{bc,ca} = \frac{C_{bc} \cdot C_{ca}}{C_{bc} + C_{ca}} \tag{2}$$

$$C_{TOT} = C_{ab} + C_{bc,ca} \tag{3}$$

As the current in the resonance circuit changes its direction, a half period of the current can be measured as a time difference between two consecutive changes in the direction of the current or in the sign of the current. Correspondingly, when the time difference between three consecutive direction changes is measured, a period of the oscillation can be measured directly. That is, a time of the half period can be determined as a time period when the sign of the current is the same and the time of the period of oscillating current can be determined as a time period of two consecutive periods with different directions or signs of the current.

Once the period of the oscillation is determined, the resonance frequency can be calculated as its inverse value of the period. Once the frequency is known, the filter capacitance can be calculated as

$$C_{TOT} = \frac{\left(\dfrac{1}{2\pi f_{res}}\right)^2}{L_{TOT}} \tag{4}$$

As it is assumed that the only changing parameter in the circuit is the resonance frequency, the mere change of resonance frequency can be used in indicating the decrease of the value of the filter capacitance.

According to an embodiment, the condition of the capacitors of the filter is determined on the basis of the determined resonance frequency or period of oscillation. According to another embodiment, the total capacitance of the filter is calculated, and the condition of the capacitors of the filter is determined on the basis of the calculated capacitance value.

The period of oscillation or the frequency can be compared with a calculated value. Such calculated value can be calculated based on nominal values of the components. Further, the determined values can be compared to previously determined values to check whether the frequency has increased or period of oscillation has grown due to aging of the capacitors.

As mentioned above, also the total capacitance can be calculated and compared with a known value which is either calculated or determined previously. In calculation of the total capacitance, the value of inductance of the resonance circuit should be known. The inductances can be estimated or calculated.

In the above embodiment, the period of oscillation was determined from the measured current. The oscillation can also be determined from the voltages of the circuit, for example from the voltages over the inductive components or from the voltages between the phases. However, in a preferred embodiment the period of oscillation is determined from the currents of the inverter as such measurements are typically employed for other purposes in the inverter circuit.

According to an embodiment the short circuit is formed also using another combination of controllable switches. The resonance frequency, period of oscillation or capacitance value is determined using three possible combinations of switches, for example. In the embodiment of Figure 2 switches T4 and T5 are controlled conductive. Once the method is applied with this combination of switches, another combination is selected, for example T4 and T6 are controlled conductive. Once the method is carried out with this combination, the last combination with lower switch components, here T5 and T6, may by selected, and the method is carried out. The purpose of selecting different combinations is to find out if the capacitances of the filter capacitors are in balance. If the obtained results, i.e. period of oscillation, calculated capacitance or resonance frequency are different, then the capacitors of the filter have different capacitances and it is concluded that capacitances of the filter are not equally spread.

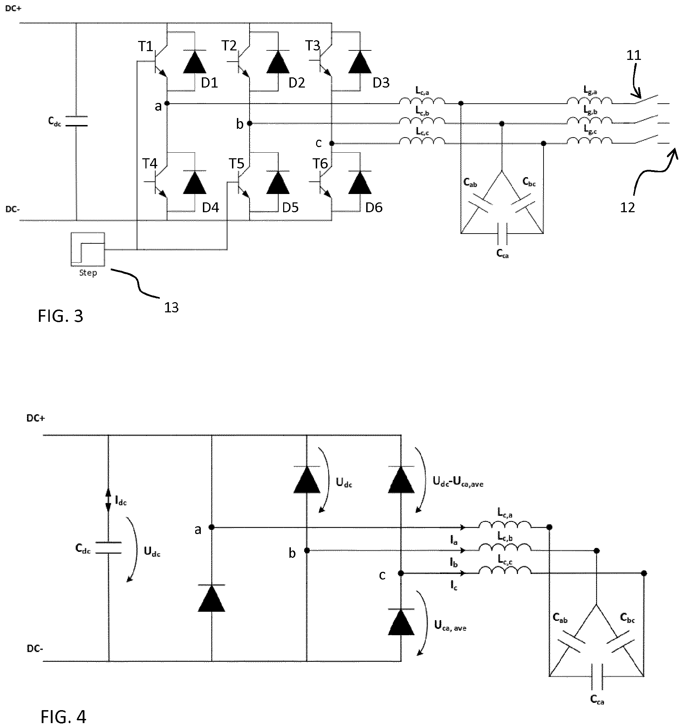

Another embodiment of the method of the invention is described in connection with Figures 3 and 4. In the embodiment, a short circuit from the filter capacitors through the filter inductors is made through at least one upper switch component and at least one lower switch component, and the at least one upper and lower switch components that are controlled conductive are not in the same inverter leg. The short circuit also includes the DC bus capacitor $C_{DC}$. As shown in Figure 3, a controller is shown to be connected to switch components T1 and T5. When these components are controlled conductive, the equivalent circuit of Figure 4 is obtained.

Thus in the embodiment a resonance circuit including the DC bus capacitor, the filter capacitors and filter inductors is formed when at least one upper switch and at least one lower switch from a different inverter leg is controller conductive. The total capacitance of the resonance circuit can be calculated as

$$C_{LC} = \frac{C_{dc} \cdot C_{TOT}}{C_{dc} + C_{TOT}} \tag{5}$$

in which $C_{TOT}$ is the capacitance of the filter and $C_{dc}$ is the capacitance of the DC bus capacitor. The capacitance of the filter and the capacitance of the DC bus are connected in series in the resonance circuit.

In the embodiment with the DC bus capacitor in the current path the resonance frequency, the period of oscillation and the capacitance of the circuit can be determined similarly as in connection with the circuit of Figures 1 and 2. That is, the period of oscillation can be determined based on measured current on voltage in the circuit as described above. The embodiment of Figures 3 and 4 enable to also determine the period of oscillation based on the current flowing in the DC bus bar and in the DC bus capacitor. The value of the total capacitance can be calculated with equation (4) when the resonance frequency is calculated and the inductances are known.

Further, in the embodiment different switch combinations can be used for determining the balance of the filter capacitances as in connection with the embodiment of Figures 1 and 2. Figure 3 shows as an example that a controller 13 is connected to control switch components T1 and T5 to obtain the resonance circuit of the embodiment. The total capacitance can be calculated with different switch combinations. In Figure 3 and 4 only one upper and one lower switch component is controlled conductive. The resonance circuit can also be built by controlling, for example, two lower side switch components and one upper side switch component conductive or by controlling two upper side and one lower side components conductive. All conductive components should also be from different converter legs.

In a case when the DC bus capacitor is charged but the filter capacitors are not charged, the embodiment enables to charge the filter capacitors by initiating a resonance with the DC bus capacitor and the filter. Once resonating, the filter capacitors are also charged, after which the embodiment without the DC bus capacitor can be initiated. The embodiment without the DC bus capacitor is somewhat more accurate as only the capacitors of interest are in the resonance current path. In the embodiment of Figures 3 and 4 the voltage of the DC bus capacitor affects the magnitude of the resonance current. It might also be possible to monitor the DC voltage prior to performing the method of the embodiment. The DC voltage should be at a suitable level to limit the resonance current.

The apparatus of the invention is an inverter with a filter The inverter comprises parallel inverter legs having upper and lower semiconductor switches with antiparallel connected diodes connected in series between positive and negative buses, wherein the points between the upper and lower semiconductor switches form the phases of the converter. The filter comprises inductive components and capacitors, the inductive components being connected to the phases of the inverter and the capacitors connecting the other ends of the inductive components.

The inverter further comprises means for charging the capacitors of the filter. Such means for charging is preferably a contactor or similar device that can connect and disconnect the filter to and from the alternating voltage source, such as AC grid. The means for charging can also be embodied as a DC bus capacitor or DC link that can be used for charging the filter capacitors as described above. The means for charging the filter capacitors may further be any known method or device that is suitable for charging the filter.

The inverter further comprises means for controlling the semiconductor switches of the inverter for short circuiting the capacitors through the inductive components while the filter is disconnected from the voltage grid. As known the semiconductor switches are controlled by applying a suitable control voltage to the control electrode of the controlled component. Further, the inverter comprises a processor or similar member which is able to carry out programmed procedures. The means for controlling the semiconductor switches in a desired manner is thus preferably a suitably programmed processor or similar controller which carries out programmed instructions. Such a controller controls driver circuits to switch desired switches so that the capacitors are short circuited through the inductive components and a resonance circuit is formed.

The inverter of the invention further comprises means for measuring a current or voltage in the circuit. Preferably the means for measuring current are current sensors used in the inverter circuit. Such current sensors are typically used for measuring phase currents during the use of the inverter.

The means for measuring current can also be a dedicated current sensor placed in the circuit for measuring the current in the resonance circuit. The means for measuring voltage can be any voltage measurement device placed in the circuit for providing measurement of the voltage. In the invention, the magnitude of the voltage is not of importance as only the zero crossings need to be indicated. According to an embodiment of the invention, the means for measuring current or voltage indicate only when the measured quantity, i.e. current or voltage, crosses zero.

The means for determining from the oscillation of the measured current or voltage the condition of the capacitors of the filter comprise a circuit that is responsive to the determined current or voltage, or to the zero crossings of current or voltage. Once the circuit receives the time instant of two consecutive zero crossing, the circuit is able to calculate the half period of the oscillating current or voltage as the time difference between the zero crossings. Further, the circuit may be implemented as a processor that can calculate the time difference. The processor may be also programmed to calculate the capacitance of the resonance circuit. Further, the means for determining the condition of the capacitors may include a memory which is accessible by the processor. The memory may include a previously determined or calculated value of the capacitance, oscillation period or resonance frequency. When a new value is determined the processor may compare the new value with a stored value to determine whether the capacitors are still in working condition or not.

The method of the invention may be implemented automatically in a timed manner when the inverter is in suitable state for carrying out the method.

As understood, the method is not to be implemented when the inverter is operating. When the inverter is turned-off after operating or has been idle for a certain period of time, the method can be carried out. In the turn-off process, the LC- or LCL-filter is disconnected from the grid, and the procedure is carried out. Once the procedure according to an embodiment of the method has finished, the inverter can be turned-off.

The method of the invention comprises a further step of providing information of the resonance frequency to the operator of the device. The information is preferably provided in a manner enabling the operator to judge whether the condition of the capacitors is good or not.

In the above embodiments the filter is presented as an LCL-filter. It is clear that the method is suitable also for checking the condition of capacitors of an LC filter. Further, the device is referred generally as being a converter or an inverter. The device may be an inverter enabling power flow only to the direction of the voltage grid, whereby the filter is an output filter. The converter device may also be a grid converter which is also able to act as a rectifier rectifying the voltage of the voltage grid. In such case the filter can be seen as an input filter.

The examples presented in the drawings relate to voltage source inverters. The method described in connection with Figures 1 and 2 can also be embodied in connection with current source inverters in which the DC bus capacitor is replaced with a DC link inductance. Further, if the stray inductances or stray capacitances of the circuit are known or estimated, these values can also be taken into account in determining the condition of the capacitors.

The resonance frequency and the period of oscillation are determined in the above described embodiments using measured intervals. The resonance frequency can also be determined by sampling the current or voltage of the resonance circuit, and using a Fourier transformation (FFT) on the samples.

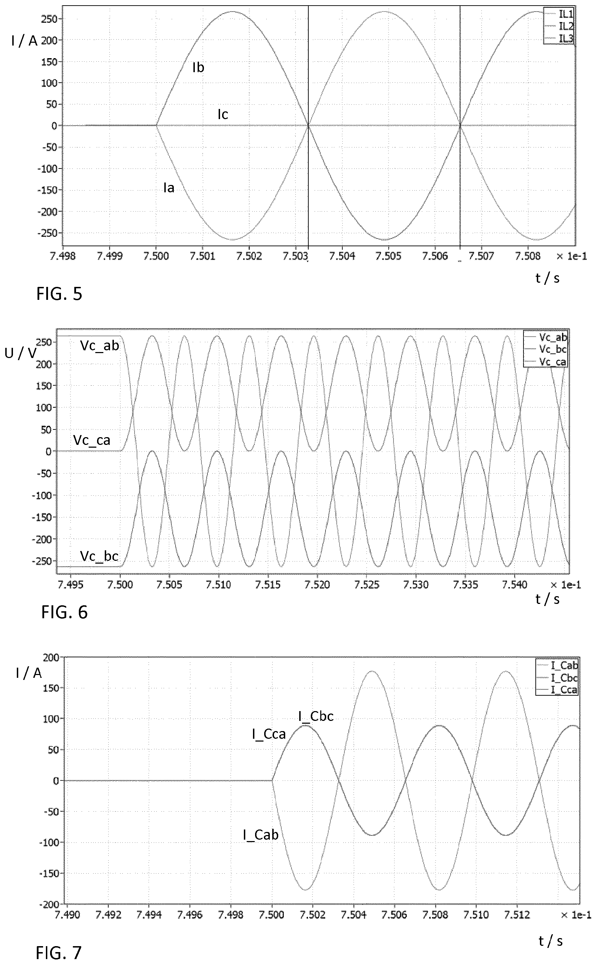

Figures 5, 6 and 7 show various simulated current and voltage waveforms relating to the embodiments of Figures 1 and 2. Figure 5 shows currents la, Ib, Ic through the filter inductors. Figure 6 shows phase-to-phase voltages which are also capacitor voltages Vc_ab, Vc_bc, Vc_ca and Figure 7 shows capacitor currents I_Cab, I_Cbc, I_Cca. It is to be noted, the currents I_Cca and I_Cba are equal. The simulated currents and voltages have a half period time of 0,325 ms which equals resonance frequency of 1529,1 Hz.

Any one of the above embodiments may be implemented by means of a computer or corresponding digital signal processing equipment provided with suitable software, for example. Such a computer or digital signal processing equipment preferably comprises at least a working memory (RAM) providing a storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of micro-instructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, which input means thus enable e.g. the monitoring of current and voltage quantities, and output means for outputting e.g. fault alarms and/or control data. It is also possible to use a specific integrated circuit or circuits, and/or discrete components and devices for implementing the functionality according to any one of the embodiments.

The invention can be implemented in existing system elements, such as various converter devices or other controllers operated in connection with converters. Present converter structures typically comprise processors and memory that can be utilized in the functions according to embodiments of the invention. Thus, all modifications and configurations required for implementing an embodiment of the invention may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept can be implemented in various ways. The invention and its embodiments are not limited to the examples described above but may vary within the scope of the claims.

## Claims

1. A method of determining condition of filter capacitance of a filter connected to the phases of an inverter and adapted to be connected to an alternating voltage source (12),

   the inverter comprising parallel connected inverter legs having upper (T1, T2, T3) and lower semiconductor switches (T4, T5, T6) with diodes (D1, D2, D3, D4, D5, D6) connected in antiparallel with the switches, the upper and lower semiconductor switches connected in series between positive and negative buses (DC+, DC-), the upper semiconductor switches being connected to the positive bus and the lower semiconductor switches being connected to the negative bus, wherein the points between the upper and lower semiconductor switches form the phases (a, b, c) of the inverter, and
   the filter comprising inductive components ($L_{c,a}$, $L_{c,b}$, $L_{c,c}$) and capacitors ($C_{ab}$, $C_{bc}$, $C_{ca}$), the inductive components being connected at their first ends to the phases of the inverter and the capacitors connecting the other ends of the inductive components,
   wherein the method comprises
   charging the capacitors of the filter,
   controlling the semiconductor switches of the inverter for short circuiting the capacitors through the inductive components while the filter is disconnected from the alternating voltage source,
   measuring a current or a voltage in the circuit comprising the filter, determining from the oscillation of the measured current or voltage a value of the filter capacitance.

2. A method according to claim 1, wherein controlling the semiconductor switches of the inverter comprises controlling two lower semiconductor switches or two upper semiconductor switches to conductive state while other semiconductor switches are in blocking state.

3. A method according to claim 1, wherein controlling the semiconductor switches of the inverter comprises controlling at least one upper semiconductor switch to conductive state and at least one lower semiconductor switch to conductive state, the components controlled in conductive state being in different inverter legs.

4. A method according to claim 1, 2 or 3, wherein the charging the capacitors of the filter comprises charging the capacitors of the filter from the alternating voltage source.

5. A method according to claim 1, 2 or 3, wherein the charging the capacitors of the filter comprises charging the capacitors of the filter from a DC bus capacitor or from the DC link.

6. A method according to any one of the previous claims 1 to 5, wherein measuring a current or a voltage comprises detecting at least two consecutive zero crossing points of the oscillating current or voltage

7. A method according to claim 6 comprising further calculating a time difference between the at least two consecutive zero crossing.

8. A method according to claim 7, wherein oscillation period of the oscillating current or voltage, or a resonance frequency of the oscillating current or voltage is determined from the calculated time difference.

9. A method according to claim 8, wherein when the inductance value of the inductive component of the filter is known, a value of capacitance of filter capacitors is calculated based on the oscillation period or resonance frequency.

10. A method according to any one of the previous claim 1 to 9, wherein the condition of the capacitors of the filter is determined on the basis of oscillation period, resonance frequency or value of filter capacitance.

11. A method according to claim 10, wherein the condition of the capacitors of the filter is determined by comparing obtained oscillation period, resonance frequency or value of filter capacitance with a previously obtained value.

12. An inverter with a filter connected to the inverter, the inverter comprising parallel connected inverter legs having upper (T1, T2, T3) and lower (T4, T5, T6) semiconductor switches with diodes (D1, D2, D3, D4, D5, D6) connected in antiparallel with the switches, the upper and lower semiconductor switches connected in series between positive and negative buses (DC+, DC-), the upper semiconductor switches being connected to the positive bus and the lower semiconductor switches being connected to the negative bus, wherein the points between the upper and lower semiconductor switches form the phases (a, b, c) of the inverter, and the filter comprising inductive components ($L_{c,a}$, $L_{c,b}$, $L_{c,c}$) and capacitors ($C_{ab}$, $C_{bc}$, $C_{ca}$), the inductive components being connected at their first ends to the phases of the inverter and the capacitors connecting the other ends of the inductive components, the inverter comprising

means for charging the capacitors of the filter,
means for controlling the semiconductor switches of the inverter for short circuiting the capacitors through the inductive components while the filter is disconnected from an alternating voltage source,
means for measuring a current or voltage in the circuit comprising the filter, and
means for determining from the oscillation of the measured current or voltage a value of the filter capacitance.

13. An inverter according to claim 12, wherein the means for controlling the semiconductor switches of the inverter comprises a controller adapted to control two lower semiconductor switches or two upper semiconductor switches to conductive state while other semiconductor switches are in blocking state or adapted to control at least one upper semiconductor switch to conductive state and at least one lower semiconductor switch to conductive state, the components controlled in conductive state being in different inverter legs.

14. An inverter according to claim 12 or 13, wherein the filter is an LC-filter or an LCL-filter.

15. A computer program product comprising computer program code, wherein the execution of the program code in a computer causes the computer to carry out the steps of the method according to any one of claims 1 to 11 with an inverter according to any of claims 12 to 14.

**Patentansprüche**

1. Verfahren zum Bestimmen des Zustands der Filterkapazität eines Filters, der mit den Phasen eines Wechselrichters verbunden ist und angepasst ist, mit einer Wechselspannungsquelle (12) verbunden zu werden,

   der Wechselrichter umfassend parallel verbundene Wechselrichterschenkel mit oberen (T1, T2, T3) und unteren Halbleiterschaltern (T4, T5, T6) mit Dioden (D1, D2, D3, D4, D5, D6), die antiparallel mit den Schaltern verbunden sind, wobei die oberen und unteren Halbleiterschalter zwischen positiven und negativen Sammelleitungen (DC+, DC-) in Reihe verbunden sind, die oberen Halbleiterschalter mit der positiven Sammelleitung verbunden sind und die unteren Halbleiterschalter mit der negativen Sammelleitung verbunden sind, wobei die Punkte zwischen den oberen und unteren Halbleiterschaltern die Phasen (a, b, c) des Wechselrichters bilden, und
   das Filter umfassend induktive Komponenten ($L_{c,a}$, $L_{c,b}$, $L_{c,c}$) und Kondensatoren ($C_{ab}$, $C_{bc}$, $C_{ca}$), wobei die induktiven Komponenten an ihren ersten Enden mit den Phasen des Wechselrichters verbunden sind und die Kondensatoren die anderen Enden der induktiven Komponenten verbinden,
   wobei das Verfahren umfasst
   Laden der Kondensatoren des Filters,
   Steuern der Halbleiterschalter des Wechselrichters zum Kurzschließen der Kondensatoren durch die induktiven Komponenten, während das Filter von der Wechselspannungsquelle abgetrennt ist,
   Messen eines Stroms oder einer Spannung in der Schaltung, die das Filter umfasst,
   Bestimmen, aus der Oszillation des gemessenen Stroms oder der gemessenen Spannung, eines Werts der Filterkapazität.

2. Verfahren nach Anspruch 1, wobei Steuern der Halbleiterschalter des Wechselrichters umfasst
   Steuern von zwei unteren Halbleiterschaltern oder zwei oberen Halbleiterschaltern in einen leitenden Zustand, während andere Halbleiterschalter in einem blockierenden Zustand sind.

3. Verfahren nach Anspruch 1, wobei Steuern der Halbleiterschalter des Wechselrichters umfasst
   Steuern mindestens eines oberen Halbleiterschalters in einen leitenden Zustand und mindestens eines unteren Halbleiterschalters in einen leitenden Zustand, wobei die Komponenten, die in einen leitenden Zustand gesteuert werden, in verschiedenen Wechselrichterschenkeln sind.

4. Verfahren nach Anspruch 1, 2 oder 3, wobei das Laden der Kondensatoren des Filters umfasst, die Kondensatoren des Filters aus der Wechselspannungsquelle zu laden.

5. Verfahren nach Anspruch 1, 2 oder 3, wobei das Laden der Kondensatoren des Filters umfasst, die Kondensatoren des Filters aus einem Gleichstrom-Sammelleitung-Kondensator oder aus der Gleichstrom-Verbindung zu laden.

6. Verfahren nach einem der vorhergehenden Ansprüche 1 bis 5, wobei Messen eines Stroms oder einer Spannung umfasst, mindestens zwei aufeinanderfolgende Nulldurchgangspunkte des oszillierenden Stroms oder der oszillierenden Spannung zu detektieren.

7. Verfahren nach Anspruch 6, ferner umfassend Berechnen einer Zeitdifferenz zwischen den mindestens zwei aufeinanderfolgenden Nulldurchgängen.

8. Verfahren nach Anspruch 7, wobei die Oszillationsperiode des oszillierenden Stroms oder der oszillierenden Spannung oder eine Resonanzfrequenz des oszillierenden Stroms oder der oszillierenden Spannung aus der berechneten Zeitdifferenz bestimmt wird.

9. Verfahren nach Anspruch 8, wobei, wenn der Induktivitätswert der induktiven Komponente des Filters bekannt ist, ein Kapazitätswert von Filterkondensatoren basierend auf der Oszillationsperiode oder der Resonanzfrequenz berechnet wird.

10. Verfahren nach einem der vorhergehenden Ansprüche 1 bis 9, wobei der Zustand der Kondensatoren des Filters basierend auf der Oszillationsperiode, der Resonanzfrequenz oder dem Wert der Filterkapazität bestimmt wird.

**11.** Verfahren nach Anspruch 10, wobei der Zustand der Kondensatoren des Filters durch Vergleichen der erlangten Oszillationsperiode, der erlangten Resonanzfrequenz oder des erlangten Werts der Filterkapazität mit einem vorher erlangten Wert bestimmt wird.

**12.** Wechselrichter mit einem Filter, das mit dem Wechselrichter verbunden ist, der Wechselrichter umfassend parallel verbundene Wechselrichterschenkel mit oberen (T1, T2, T3) und unteren (T4, T5, T6) Halbleiterschaltern mit Dioden (D1, D2, D3, D4, D5, D6), die antiparallel mit den Schaltern verbunden sind, wobei die oberen und unteren Halbleiterschalter zwischen positiven und negativen Sammelleitungen (DC+, DC-) in Reihe verbunden sind, die oberen Halbleiterschalter mit der positiven Sammelleitung verbunden sind und die unteren Halbleiterschalter mit der negativen Sammelleitung verbunden sind, wobei die Punkte zwischen den oberen und unteren Halbleiterschaltern die Phasen (a, b, c) des Wechselrichters bilden, und das Filter umfassend induktive Komponenten ($L_{c,a}$, $L_{c,b}$, $L_{c,c}$) und Kondensatoren ($C_{ab}$, $C_{bc}$, $C_{ca}$), wobei die induktiven Komponenten an ihren ersten Enden mit den Phasen des Wechselrichters verbunden sind und die Kondensatoren die anderen Enden der induktiven Komponenten verbinden,

der Wechselrichter umfassend
Mittel zum Laden der Kondensatoren des Filters, Mittel zum Steuern der Halbleiterschalter des Wechselrichters zum Kurzschließen der Kondensatoren durch die induktiven Komponenten, während das Filter von einer Wechselspannungsquelle abgetrennt ist,
Mittel zum Messen eines Stroms oder einer Spannung in der Schaltung, die das Filter umfasst, und
Mittel zum Bestimmen, aus der Oszillation des gemessenen Stroms oder der gemessenen Spannung, eines Werts der Filterkapazität.

**13.** Wechselrichter nach Anspruch 12, wobei die Mittel zum Steuern der Halbleiterschalter des Wechselrichters ein Steuergerät umfassen, das angepasst ist zum Steuern von zwei unteren Halbleiterschaltern oder zwei oberen Halbleiterschaltern in einen leitenden Zustand, während andere Halbleiterschalter in einem blockierenden Zustand sind, oder angepasst ist zum Steuern mindestens eines oberen Halbleiterschalters in einen leitenden Zustand und mindestens eines unteren Halbleiterschalters in einen leitenden Zustand, wobei die Komponenten, die in einen leitenden Zustand gesteuert werden, in verschiedenen Wechselrichterschenkeln sind.

**14.** Wechselrichter nach Anspruch 12 oder 13, wobei das Filter ein LC-Filter oder ein LCL-Filter ist.

**15.** Computerprogrammprodukt, umfassend Computerprogrammcode, wobei die Ausführung des Programmcodes in einem Computer den Computer veranlasst, die Schritte des Verfahrens nach einem der Ansprüche 1 bis 11 mit einem Wechselrichter nach einem der Ansprüche 12 bis 14 auszuführen.

**Revendications**

**1.** Procédé de détermination d'un état de capacité de filtre d'un filtre connecté aux phases d'un onduleur et adapté à être connecté à une source de tension alternative (12),

l'onduleur comprenant des branches d'onduleur connectées en parallèle pourvues d'interrupteurs à semi-conducteur supérieurs (T1, T2, T3) et inférieurs (T4, T5, T6) avec des diodes (D1, D2, D3, D4, D5, D6) connectées en antiparallèle avec les interrupteurs, les interrupteurs à semi-conducteur supérieurs et inférieurs étant connectés en série entre des bus positif et négatif (DC+, DC-), les interrupteurs à semi-conducteur supérieurs étant connectés au bus positif et les interrupteurs à semi-conducteur inférieurs étant connectés au bus négatif, les points entre les interrupteurs à semi-conducteur supérieurs et inférieurs formant les phases (a, b, c) de l'onduleur, et
le filtre comprenant des composants inductifs ($L_{c,a}$, $L_{c,b}$, $L_{c,c}$) et des condensateurs ($C_{ab}$, $C_{bc}$, $C_{ca}$), les composants inductifs étant connectés, à leurs premières extrémités, aux phases de l'onduleur et les condensateurs connectant les autres extrémités des composants inductifs,
le procédé comprenant
la charge des condensateurs du filtre,
la commande des interrupteurs à semi-conducteur de l'onduleur pour court-circuiter les condensateurs à travers les composants inductifs alors que le filtre est déconnecté de la source de tension alternative,
la mesure d'un courant ou d'une tension dans le circuit comprenant le filtre,
la détermination, à partir de l'oscillation du courant mesuré ou de la tension mesurée, d'une valeur de la capacité de filtre.

**2.** Procédé selon la revendication 1, dans lequel la commande des interrupteurs à semi-conducteur de l'onduleur comprend
la commande de deux interrupteurs à semi-conducteur inférieurs ou de deux interrupteurs à semi-conducteur supérieurs vers l'état conducteur alors que d'autres interrupteurs à semi-conducteur sont à l'état bloquant.

**3.** Procédé selon la revendication 1, dans lequel la commande des interrupteurs à semi-conducteur de l'onduleur comprend
la commande d'au moins un interrupteur à semi-conducteur supérieur vers l'état conducteur et d'au moins un interrupteur à semi-conducteur inférieur vers l'état conducteur, les composants commandés dans l'état conducteur se situant dans des branches d'onduleur différentes.

**4.** Procédé selon la revendication 1, 2 ou 3, dans lequel la charge des condensateurs du filtre comprend la charge des condensateurs du filtre à partir de la source de tension alternative.

**5.** Procédé selon la revendication 1, 2 ou 3, dans lequel la charge des condensateurs du filtre comprend la charge des condensateurs du filtre à partir d'un condensateur de bus à courant continu ou à partir de la liaison à courant continu.

**6.** Procédé selon l'une quelconque des revendications 1 à 5 précédentes, dans lequel la mesure d'un courant ou d'une tension comprend la détection d'au moins deux points de passage par zéro consécutifs du courant oscillant ou de la tension oscillante.

**7.** Procédé selon la revendication 6, comprenant en outre le calcul d'une différence de temps entre les au moins deux passages par zéro consécutifs.

**8.** Procédé selon la revendication 7, dans lequel la période d'oscillation du courant oscillant ou de la tension oscillante, ou une fréquence de résonance du courant oscillant ou de la tension oscillante est déterminée à partir de la différence de temps calculée.

**9.** Procédé selon la revendication 8, dans lequel, lorsque la valeur d'inductance du composant inductif du filtre est connue, une valeur de capacité de condensateurs de filtre est calculée sur la base de la période d'oscillation ou de la fréquence de résonance.

**10.** Procédé selon l'une quelconque des revendications 1 à 9 précédentes, dans lequel l'état des condensateurs du filtre est déterminé sur la base de la période d'oscillation, de la fréquence de résonance ou de la valeur de capacité de filtre.

**11.** Procédé selon la revendication 10, dans lequel l'état des condensateurs du filtre est déterminé par comparaison de la période d'oscillation, de la fréquence de résonance ou de la valeur de capacité de filtre obtenue à une valeur précédemment obtenue.

**12.** Onduleur avec un filtre connecté à l'onduleur, l'onduleur comprenant des branches d'onduleur connectées en parallèle pourvues d'interrupteurs à semi-conducteur supérieurs (T1, T2, T3) et inférieurs (T4, T5, T6) avec des diodes (D1, D2, D3, D4, D5, D6) connectées en antiparallèle avec les interrupteurs, les interrupteurs à semi-conducteur supérieurs et inférieurs étant connectés en série entre des bus positif et négatif (DC+, DC-), les interrupteurs à semi-conducteur supérieurs étant connectés au bus positif et les interrupteurs à semi-conducteur inférieurs étant connectés au bus négatif, les points entre les interrupteurs à semi-conducteur supérieurs et inférieurs formant les phases (a, b, c) de l'onduleur, et le filtre comprenant des composants inductifs ($L_{c,a}$, $L_{c,b}$, $L_{c,c}$) et des condensateurs ($C_{ab}$, $C_{bc}$, $C_{ca}$), les composants inductifs étant connectés, à leurs premières extrémités, aux phases de l'onduleur et les condensateurs connectant les autres extrémités des composants inductifs,

l'onduleur comprenant
des moyens de charge des condensateurs du filtre, des moyens de commande des interrupteurs à semi-conducteur de l'onduleur pour court-circuiter les condensateurs à travers les composants inductifs alors que le filtre est déconnecté de la source de tension alternative,
des moyens de mesure d'un courant ou d'une tension dans le circuit comprenant le filtre, et
des moyens de détermination, à partir de l'oscillation du courant mesuré ou de la tension mesurée, d'une valeur de la capacité de filtre.

**13.** Onduleur selon la revendication 12, dans lequel les moyens de commande des interrupteurs à semi-conducteur de l'onduleur comprennent un contrôleur adapté à commander deux interrupteurs à semi-conducteur inférieurs ou deux interrupteurs à semi-conducteur supérieurs vers l'état conducteur alors que d'autres interrupteurs à semi-conducteur sont à l'état bloquant, ou adapté à commander au moins un interrupteur à semi-conducteur supérieur vers l'état conducteur et au moins un interrupteur à semi-conducteur inférieur vers l'état conducteur, les composants commandés dans l'état conducteur se situant dans des branches d'onduleur différentes.

**14.** Onduleur selon la revendication 12 ou 13, dans lequel le filtre est un filtre LC ou un filtre LCL.

**15.** Produit-programme d'ordinateur comprenant un code de programme d'ordinateur, l'exécution du code de programme dans un ordinateur amenant l'ordinateur à mettre en œuvre les étapes du procédé selon l'une quelconque des revendications 1 à 11 avec un onduleur selon l'une quelconque des revendications 12 à 14.

FIG. 1

FIG. 2

FIG. 3

FIG. 4

FIG. 5

FIG. 6

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015071378 A1

- US 2013057297 A1